# EUROPEAN PATENT APPLICATION

(11) **EP 4 769 054 A1**
(43) Date of publication of application: **01.07.2026**
(21) Application number: 25224349.8
(22) Date of filing: 17.12.2025
(51) Int. Cl.: G05D 7/06, G05D 11/13

(54) **GAS SUPPLY SYSTEM, PROCESSING APPARATUS, GAS SUPPLY METHOD, AND METHOD OF MANUFACTURING SEMICONDUCTOR DEVICE**

(30) Priority: 27.12.2024 JP 2024232986
(71) Applicant: Kokusai Electric Corporation, Tokyo 101-0045 (JP)
(72) Inventor: TANAKA, Shoki, Toyama-shi, Toyama, 939-2393 (JP)
(74) Representative: Bardehle Pagenberg Partnerschaft mbB Patentanwälte Rechtsanwälte

(57) **Abstract**

A technique includes a gas supply system including: a plurality of gas supply lines connected to a process chamber, wherein each of the plurality of gas supply lines includes an inlet-side valve through which a gas flows in, a storage in which the gas is accumulated through the inlet-side valve, and an outlet-side valve through which the gas flows out of the storage; and a regulator installed in at least one of the plurality of gas supply lines and is configured to be capable of regulating a flow path resistance of the gas supply line such that gas supply amounts from the plurality of gas supply lines into the process chamber are matched.

## Description

### CROSS-REFERENCE TO RELATED APPLICATION

This application is based upon and claims the benefit of priority from Japanese Patent Application No. 2024-232986, filed on December 27, 2024, the entire content of which is incorporated herein by reference.

### TECHNICAL FIELD

The present disclosure relates to a gas supply system, a processing apparatus, a gas supply method, and a method of manufacturing a semiconductor device.

### BACKGROUND

As an example of a semiconductor manufacturing apparatus, which is a type of processing apparatus for manufacturing a semiconductor device, an apparatus configured to process a plurality of substrates has been disclosed in the related art. In addition, it is described that, when processing a substrate by supplying gases into a process chamber by a dual pipeline, gas accumulation in tanks provided for the respective pipelines and gas discharge into the process chamber are alternately repeated to process the substrate. However, it may be difficult to match the gas supply amount from the respective pipelines into the process chamber.

### SUMMARY

The present disclosure provides a technique for matching gas supply amounts from respective gas supply lines into a process chamber.

According to some embodiments of the present disclosure, there is provided a technique that includes a gas supply system including: a plurality of gas supply lines connected to a process chamber, wherein each of the plurality of gas supply lines includes an inlet-side valve through which a gas flows in, a storage in which the gas is accumulated through the inlet-side valve, and an outlet-side valve through which the gas flows out of the storage; and a regulator installed at at least one of the plurality of gas supply lines and is configured to be capable of regulating a flow path resistance of the gas supply line such that gas supply amounts from the plurality of gas supply lines into the process chamber are matched.

### BRIEF DESCRIPTION OF DRAWINGS

The accompanying drawings, which are incorporated in and constitute a part of the specification, illustrate embodiments of the present disclosure.
FIG. 1 is a schematic diagram illustrating a schematic configuration of a substrate processing apparatus according to some embodiments of the present disclosure.
FIG. 2 is a schematic configuration diagram of a controller of the substrate processing apparatus according to some embodiments of the present disclosure, illustrating a control system of the controller in a block diagram.
FIG. 3 is a time chart illustrating an example of the opening/closing timings of respective valves in the substrate processing apparatus according to some embodiments of the present disclosure.
FIG. 4A is a schematic diagram illustrating an ideal state of respective gas supply lines.
FIG. 4B is a schematic diagram illustrating an example of an actual state of respective gas supply lines.
FIG. 5 is a graph illustrating gas supply amounts of when the respective gas supply lines of FIG. 4B are used.
FIG. 6A is a schematic diagram illustrating a schematic configuration of a substrate processing apparatus using respective gas supply lines of a Comparative Example.
FIG. 6B is a schematic diagram illustrating a schematic configuration of a substrate processing apparatus using respective gas supply lines of an Example.
FIG. 6C is a graph illustrating gas supply amounts when the respective gas supply lines of FIGS. 6A and 6B are used.
FIG. 7A is a schematic diagram illustrating a gas supply line according to a modification.
FIG. 7B is a schematic diagram illustrating a gas supply line according to a modification.
FIG. 7C is a schematic diagram illustrating a schematic configuration of a substrate processing apparatus using a gas supply line of a modification.
FIG. 7D is a schematic diagram illustrating a schematic configuration of a substrate processing apparatus using a gas supply line of a modification.
FIG. 8 is a schematic diagram illustrating a gas supply line of a modification.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### [Embodiments of Present Disclosure]

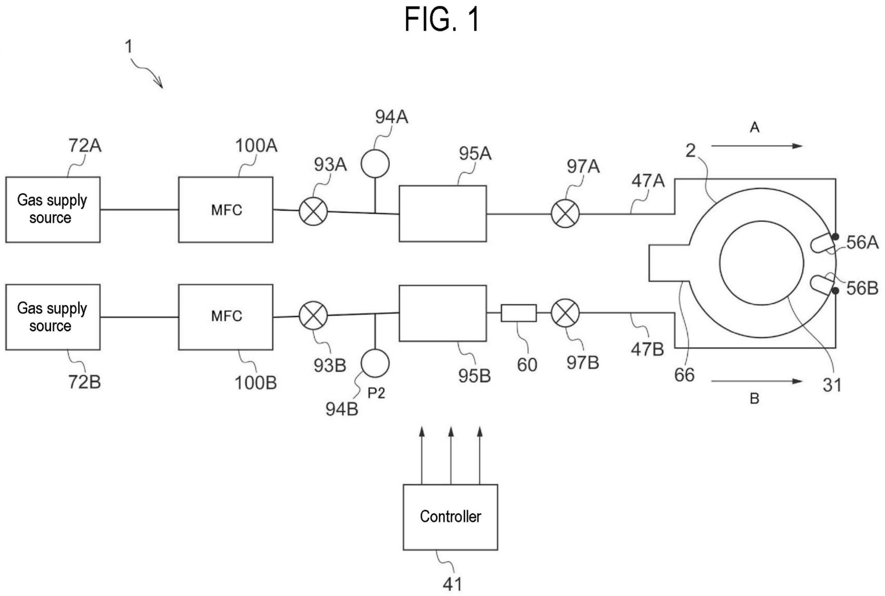

Hereinafter, embodiments of the present disclosure will be described mainly with reference to FIGS. 1 to 5. In addition, the drawings used in the following description are schematic, and dimensional relationships, proportions, and the like of respective elements illustrated in the drawings may not match actual ones. Further, dimensional relationships, proportions, and the like of respective elements may not match one another among multiple drawings.

FIG. 1 is a schematic diagram illustrating a schematic configuration of a substrate processing apparatus 1 as a processing apparatus according to some embodiments of the present disclosure.

A process chamber 2, where a substrate 31 is loaded into and processed in, is installed with two nozzles, i.e., a first nozzle 56A and a second nozzle 56B, which discharge gases to an interior of the process chamber 2. A gas is supplied to the first nozzle 56A from a gas supply source 72A. A gas is supplied to the second nozzle 56B from a gas supply source 72B. A gas flow path from the gas supply source 72A to the first nozzle 56A is constituted by a first gas supply line (hereinafter referred to as a "first supply line") 47A. Further, a gas flow path from the gas supply source 72B to the second nozzle 56B is constituted by a second gas supply line (hereinafter referred to as a "second supply line") 47B. In addition, the first supply line 47A and the second supply line 47B of the present embodiment are examples of a plurality of gas supply lines in the present disclosure. In the drawing, arrows labeled "A" and "B" respectively indicate directions in which the gases in the first supply line 47A and the second supply line 47B flow. The gas supply sources 72A and 72B may be a single supply source. Further, the gas supply sources 72A and 72B may supply the same type of gas or may supply different types of gases. Meanwhile, an exhaust duct 66 is installed at a downstream side of the process chamber 2 to discharge the processed gas.

The process chamber 2 may be constituted by a reaction tube in a vertical furnace. In such a case, a plurality of substrates 31 are disposed in multiple stages in the process chamber 2. The first nozzle 56A and the second nozzle 56B are capable of ejecting gases from a lateral side of the substrates 31 disposed in multiple stages, so as to form a gas flow that is parallel to surfaces of the respective substrates 31. The first nozzle 56A and the second nozzle 56B may be configured, for example, to be planarsymmetric with respect to a plane that is perpendicular to the substrates 31 and passes through the center of the substrates 31. The process chamber 2 is depressurized, for example, to 100 Pa or less by a vacuum pump connected to the exhaust duct 66.

The first supply line 47A is installed, sequentially from the most upstream gas supply source 72A toward the most downstream first nozzle 56A, with a mass flow controller (hereinafter referred to as "MFC") 100A serving as a flow-rate controller, an inlet-side valve 93A serving as a first introducer, a first tank 95A (hereinafter referred to as a "first tank") serving as a storage, and an outlet-side valve 97A serving as a first discharger, which are connected in series. Further, the first supply line 47A includes a pipe 48A. The gas supply source 72A, MFC 100A, inlet-side valve 93A, first tank 95A, outlet-side valve 97A, and first nozzle 56A are connected by the pipe 48A. A pressure sensor 94A is installed in a portion of the pipe 48A between the inlet-side valve 93A and the first tank 95A.

The second supply line 47B is installed, sequentially from the most upstream gas supply source 72B toward the most downstream second nozzle 56B, with a MFC 100B, an inlet-side valve 93B serving as a second introducer, a second tank 95B (hereinafter referred to as a "second tank") serving as a storage, and an outlet-side valve 97B serving as a second discharger, which are connected in series. Further, the second supply line 47B includes a pipe 48B. The gas supply source 72B, MFC 100B, inlet-side valve 93B, second tank 95B, outlet-side valve 97B, and second nozzle 56B are connected by the pipe 48B. The pressure sensor 94B is installed in a portion of the pipe 48B between the inlet-side valve 93B and the second tank 95B.

The first tank 95A and the second tank 95B are of substantially the same volume and respectively accumulate the gases delivered from the gas supply sources 72A and 72B via the MFCs 100A and 100B. Then, the accumulated gases are discharged for a shorter time than a time for which the gases were accumulated, thereby achieving a pulsed gas supply of a large flow rate and the surface of the substrate 31 is uniformly exposed to the gases. Supplying the gases as such may be effective in performing film formation with good uniformity and step coverage on the substrate 31 with a pattern such as a groove with a width smaller than the mean free path of gas. Further, in supplying the gases as such, the gases may be supplied with an error of 1% or less with respect to a standard flow rate or flow velocity per unit time (e.g., per minute or per second).

When the inlet-side valves 93A and 93B are opened, the gases with controlled constant mass flow rates flow from the MFCs 100A and 100B into the first and second tanks 95A and 95B, respectively. Further, when the gases are accumulated in the first and second tanks 95A and 95B, each of the pressure sensors 94A and 94B detect an increase in pressure in the respective flow paths. In response to the detection of this pressure increase, a controller 41, which will be described later, closes the inlet-side valves 93A and 93B respectively, thereby stopping the gases from flowing into the first and second tanks 95A and 95B.

The outlet-side valve 97A is installed at the first supply line 47A connecting the gas supply source 72A to the first nozzle 56A that discharges the gas into the process chamber 2, and controls the discharge of gas from the first nozzle 56A.

The outlet-side valve 97B is installed at the second supply line 47B connecting the gas supply source 72B to the second nozzle 56B that discharges the gas into the process chamber 2, and controls the discharge of gas from the second nozzle 56B.

The gases supplied from the gas supply sources 72A and 72B into the process chamber 2 may be, for example, the same type of gas. The gas supplied into the process chamber 2 may be, for example, a gas containing a vaporized or sublimated gaseous precursor (precursor gas). Further, the gas may be a gas mixture (mixed gas) of a precursor gas and an inert gas (e.g., a carrier gas).

When the out-let side valve 97A is opened, the gas accumulated in the first tank 95A is discharged from the first nozzle 56A into the process chamber 2 via the first supply line 47A when the outlet-side valve 97A is opened. Likewise, when the outlet-side valve 97B is opened, the gas accumulated in the second tank 95B is discharged from the second nozzle 56B into the process chamber 2 via the second supply line 47B.

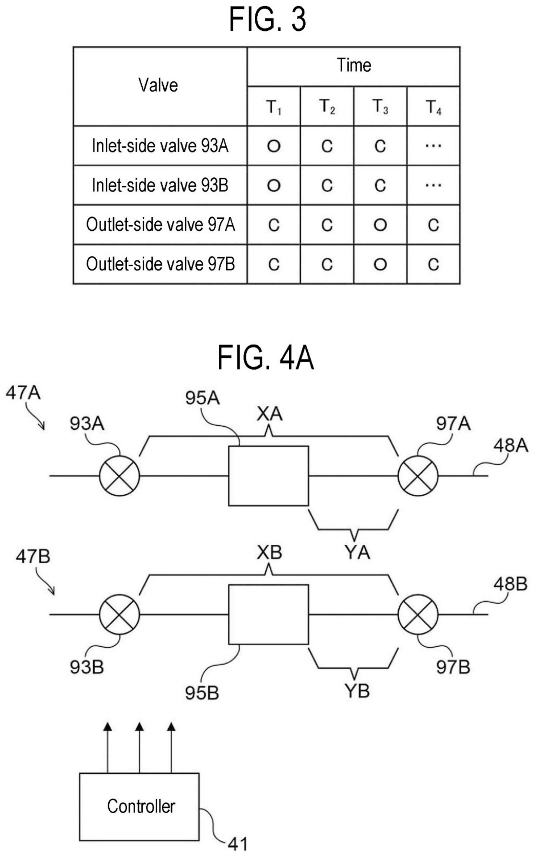

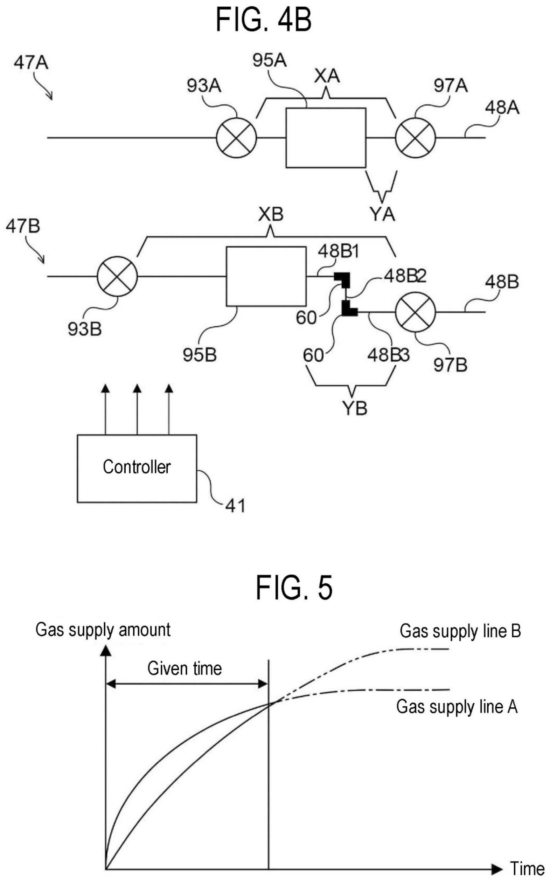

When the same type of gas is stored in the first and second tanks 95A and 95B and is supplied into the process chamber 2 from the respective gas supply lines, in order to match the flow rates among the respective gas supply lines, the volumes between the inlet-side and outlet-side valves are matched, and therefore the gas supply lines are formed in the same piping shape. FIG. 4A illustrates an ideal piping shape in which the gas supply lines are formed in the same piping shape. However, as illustrated in FIG. 4B, the pipes 48A and 48B from the gas supply sources 72A and 72B to the process chamber 2 are often formed in different piping shapes in practice. Accordingly, the discloser of the present disclosure has discovered a technique in which, even when the piping shapes of the respective gas supply lines differ, i.e., when the volumes between the inlet-side and outlet-side valves do not match as illustrated in FIG. 4B, the gas supply amounts within a given time among the respective gas supply lines match by regulating flow rates or flow velocities of the gases.

As illustrated in FIG. 4B, in the present embodiment, the volume from the inlet-side valve 93A to the outlet-side valve 97A in the first supply line 47A and the volume from the inlet-side valve 93B to the outlet-side valve 97B in the second supply line 47B differ. Therefore, at least one selected from the group of the first and second gas supply lines 47A and 47B is installed with a regulator 60. The regulator 60 is a pipe member with a function of regulating a flow path resistance in the gas supply line. In addition, the term "volume" of the gas supply line refers to the volume from the inlet-side valve and the outlet-side valve. Hereinafter, the volume of the first supply line 47A is represented by XA, and the volume of the second supply line 47B is represented by XB. In addition, the term "flow path resistance" of the gas supply line refers to the flow path resistance in a region from the storage to the outlet-side valve. Hereinafter, the flow path resistance of the first supply line 47A is represented by YA, and the flow path resistance of the second supply line 47B is represented by YB.

In the present embodiment, the gas supply amounts from the first supply line 47A and the second supply line 47B into the process chamber 2 are matched by the regulator 60. That is, the regulator 60 is a pipe member that is installed at at least one selected from the group of the first supply line 47A and the second supply line 47B and is configured to be capable of matching the gas supply amounts within at least a given time from the first supply line 47A and the second supply line 47B into the process chamber 2. In addition, the term "gas supply amount" herein refers to an accumulated amount of gas that is supplied (also referred to as discharged) into the process chamber 2. Further, as in FIG. 5, which illustrates slight mismatches in gas supply amounts over a given time, it is difficult to exactly match the gas supply amounts from the first supply line 47A and the second supply line 47B into the process chamber 2 with zero error. Thus, the "matching the supply amounts" herein refers to a case where the difference in gas supply amounts over a given time among the respective gas supply lines is less than ± 10%, for example, within ±3%. In addition, the difference in gas supply amounts over a given time among the respective gas supply lines may be within ± 1%, as described above.

Further, the case where the volumes XA and XB of the respective gas supply lines differ includes at least one case selected from the group of, a case where a length of pipe from the inlet-side valve 93A to the first tank 95A in the first supply line 47A and a length of pipe from the inlet-side valve 93B to the second tank 95B in the second supply line 47B differ, a case where a length of pipe from the first tank 95A to the outlet-side valve 97A and a length of pipe from the second tank 95B to the outlet-side valve 97B differ, and a case where a volume of the first tank 95A and a volume of the second tank 95B differ.

In the present embodiment, as illustrated in FIG. 4B, the second supply line 47B is installed with the regulator 60. Specifically, the regulator 60 is installed between the second tank 95B and the outlet-side valve 97B of the second supply line 47B.

The regulator 60 is a connection pipe (so-called joint) that connects pipes that constitute the second supply line 47B. Examples of the connection pipe may include an elbow pipe, a bellows pipe, and a reducer pipe. In the present embodiment, an elbow pipe is used as the connection pipe. In addition to the elbow pipe, a pipe bent at an angle of, for example, 45 degrees or 180 degrees, i.e. a pipe capable of changing the flow path, may also be used as the connection pipe.

In the present embodiment, as an example, two regulators 60 are installed between the second tank 95B and the outlet-side valve 97B. Three pipes 48B1, 48B2, and 48B3 constituting the pipe 48B are arranged between the second tank 95B and the outlet-side valve 97B of the second supply line 47B. The pipe 48B 1 connects the second tank 95B and the first regulator 60. The pipe 48B2 connects the first regulator 60 and the second regulator 60. The pipe 48B3 connects the second regulator 60 and the outlet-side valve 97B.

Here, the matching the gas supply amounts within a given time based on the relationship between the volumes XA and XB illustrated in FIG. 4B and the flow path resistances will be described with reference to FIG. 5. In addition, the example illustrated in FIG. 4B will be referred to as an Example, and an example in which the regulator 60 is omitted from the configuration illustrated in FIG. 4B will be referred to as a Comparative Example. In the Comparative Example, since the flow path resistances of the respective gas supply lines are substantially the same and the volume XA is less than the volume XB, the gas supply amount is larger in the second supply line 47B than in the first supply line 47A. Therefore, in the Example, the flow path resistance of the second supply line 47B is regulated (increased) by installing the regulator 60 in the second supply line 47B. FIG. 5 illustrates the gas supply amounts in the first supply line 47A and the second supply line 47B. In the Example, based on the relationship between the volumes XA and XB (the volume XA is less than the volume XB), the relationship between the flow path resistances is regulated by the regulator 60 such that the flow path resistance of the first supply line 47A is less than the flow path resistance of the second supply line 47B, and it can be seen that the gas supply amounts are matched over a given time, by increasing the flow path resistance of the second supply line 47B. In other words, with a design in which the flow path resistances between the tanks 95A and 95B and the outlet-side valves 97A and 97B are regulated based on the difference between the volumes XA and XB, the gas supply amounts may be matched over a given time by regulating the flow path resistance to provide a difference in supply speed of the gas even when there is a volume difference among the respective gas supply lines. In addition, when volume XA is larger than the volume XB, the regulator 60 may be installed in the first supply line 47A to increase the flow path resistance in the first supply line 47A than in the second supply line 47B.

Accordingly, in the actual piping arrangement from the gas supply source to the process chamber 2, the volumes of the respective gas supply lines are different, with one having a larger volume than the other. In such a case, the gas supply amounts of the respective gas supply lines may be matched over a predetermined time by using the regulator 60.

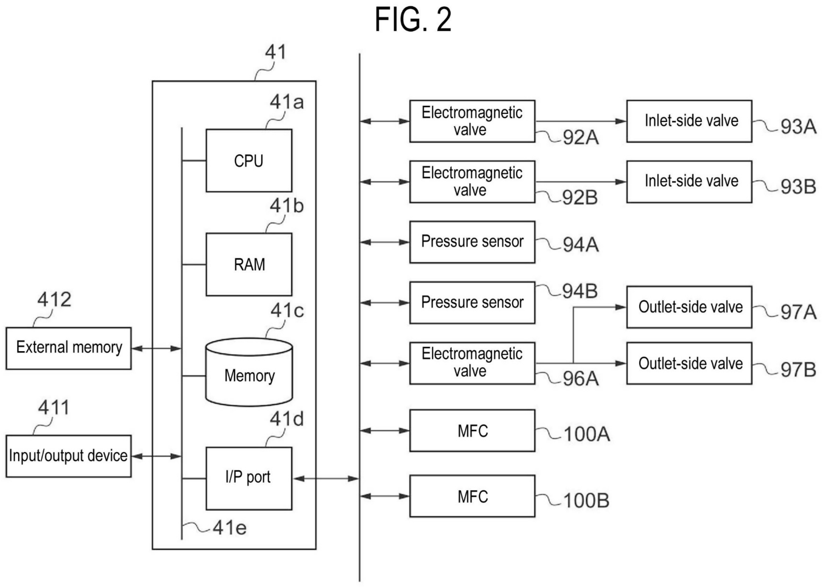

Further, the substrate processing apparatus 1 includes the controller 41 that controls operations of each component. The controller 41 is schematically illustrated in FIG. 2. The controller 41, which serves as a processor (processing means or unit), is constituted as a computer including a central processing unit (CPU) 41a, a random access memory (RAM) 41B, a memory 41c, and an I/O port 41d. The RAM 41B, the memory 41c, and the I/O port 41d are configured to be capable of exchanging data with the CPU 41a via an internal bus 41e. The controller 41 is configured to be capable of being connected to an input/output device 411 which is constituted as, for example, as a touch panel, and to an external memory 412.

The memory 41c is constituted by, for example, a flash memory or a hard disk drive (HDD). The memory 41c stores, in a readable manner, control programs for controlling the operations of the substrate processing apparatus 1, process recipes describing procedures, conditions and others of the substrate processing, correction recipes, and others. Further, the RAM 41B is constituted as a memory area (work area) where programs, data, and others read by the CPU 41a are temporarily stored.

The I/O port 41d is connected to the above-described pressure sensors 94A and 94B and the MFCs 100A and 100B and also to electromagnetic valves 92A and 92B that open or close the inlet-side valves 93A and 93B, respectively.

The controller 41 controls the inlet-side and outlet-side valves 93A and 97A, and the inlet-side and outlet-side valves 93B and 97B, so as to alternately repeat the accumulation of gases in the first tank 95A and the second tank 95B and the discharge of gases from the first tank 95A and the second tank 95B.

The controller 41 calculates the gas supply amount in the first supply line 47A based on the volume XA from the inlet-side valve 93A to the outlet-side valve 97A via the first tank 95A and the flow path resistance from the first tank 95A to the outlet-side valve 97A. Further, the controller 41 calculates the gas supply amount in the second supply line 47B based on the volume XB from the inlet-side valve 93B to the outlet-side valve 97B via the second tank 95B and the flow path resistance from the second tank 95B to the outlet-side valve 97B. Then, the controller 41 may predict a time at which the calculated gas supply amounts are matched. Further, the controller 41 may arbitrarily display information such as the gas supply amount of the first supply line 47A over a given time, the gas supply amount of the second supply line 47B over a given time, the difference between the respective gas supply amounts, the time at which the calculated gas supply amounts are matched, and the prediction result (indicating whether the gas supply amounts match or not) on a display device . Thus, it becomes possible to regulate the time at which the gas supply amounts among the respective gas supply lines are matched by the regulator. For example, in a case illustrated in FIG. 5, by adding an additional regulator to the second supply line 47B, it is possible to further increase the flow path resistance and to shorten the time at which the gas supply amounts among the respective gas supply lines are matched. Further, when the volumes XA and XB of the respective gas supply lines are the same, the controller 41 may display on the display device that the flow path resistance may not be regulated by the regulator 60.

The controller 41 may be constituted as a dedicated computer or as a general-purpose computer. For example, the controller 41 of the present embodiment may be configured by preparing the external memory 412 (e.g., a semiconductor memory such as a USB memory or a memory card) in which the programs described above are stored, and installing the programs into a general-purpose computer by using the external memory 412. In addition, a way of supplying the programs to the computer is not limited to the case of supplying via the external memory 412. For example, the programs may be supplied by using a communication means or unit such as the Internet or a dedicated communication line without using the external memory 412. Further, the memory 41c and the external memory 412 are constituted as computer-readable recording media. Hereinafter, these are generally and simply referred to as the "recording medium." In addition, the term "recording medium" as used herein may refer to a case of including the memory 41c, a case of including the external memory 412, or a case of including both the memory 41c and the external memory 412.

### <Opening/Closing Timing of Each Valve>

Next, the opening/closing timing of each valve in the substrate processing apparatus 1 of the present embodiment will be described with reference to the time chart of FIG. 3. In FIG. 3, "O" indicates that the valve is in an open state, "C" indicates that the valve is in a closed state, and "···" indicates an arbitrary state.

First, at time T₁, the inlet-side valves 93A and 93B are opened, and gas accumulation into the first tank 95A and second tank 95B is performed. Then, at time T₂, the inlet-side valves 93A and 93B are closed, and a state in which the gases have been accumulated to a predetermined pressure is maintained. Then, at time T₃, when the controller 41 opens the outlet-side valves 97A and 97B with both the first tank 95A and the second tank 95B filled with the gases, the gas accumulated in the first tank 95A passes through the first supply line 47A from the outlet-side valve 97A and is discharged from the first nozzle 56A into the process chamber 2, while the gas accumulated in the second tank 95B passes through the second supply line 47B from the outlet-side valve 97B and is discharged from the second nozzle 56B into the process chamber 2. In addition, the discharge of gas from the first nozzle 56A and the discharge of gas from the second nozzle 56B may not be simultaneous, and an appropriate time difference may be provided (the same applies hereinafter). A gas supply time to the process chamber 2 is, for example, less than 1 minute (for example, several seconds to several tens of seconds). Therefore, the regulator may be used such that the gas supply amounts of the respective gas supply lines are matched within the gas supply time to the process chamber 2. Then, at time T₄, the outlet-side valves 97A and 97B are closed, and the process chamber 2 is exhausted. At this time, a purge gas or another film-forming gas may be supplied from another supply system (not illustrated).

The controller 41 included in the substrate processing apparatus 1 of the present embodiment is configured to be capable of controlling the outlet-side valve 97A to open when a predetermined amount of gas has been accumulated in the first tank 95A, and the outlet-side valve 97B to open when a predetermined amount of gas has been accumulated in the second tank 95B.

By performing a sequence of operations from time T₁ to time T₄ once or more, the substrate 31 is exposed to the gases, and substrate processing such as film formation is achieved. Furthermore, the sequence of operations may be repeated a plurality of times while rotating the substrate 31.

### <Modifications>

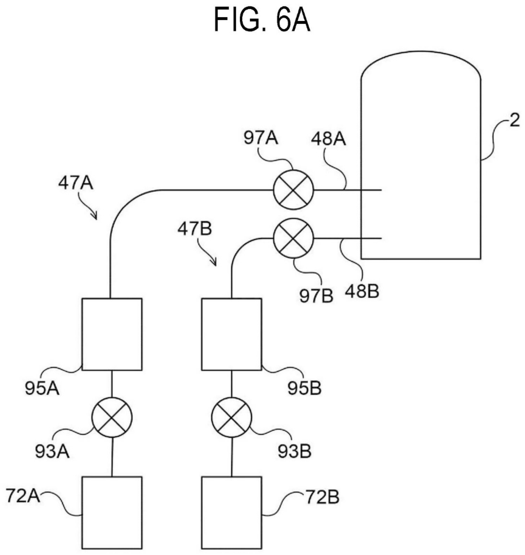

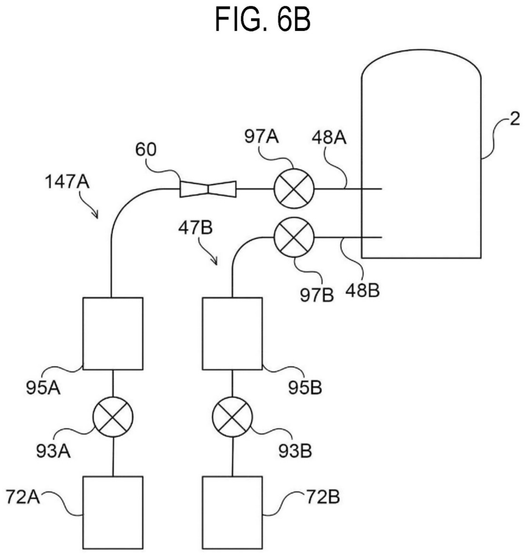

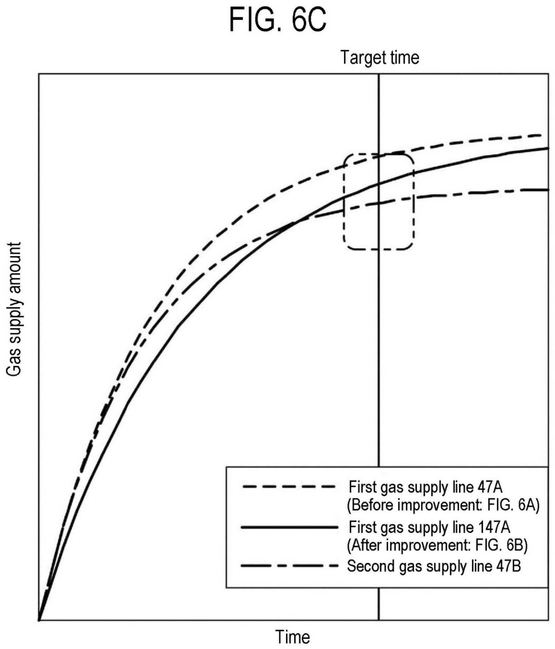

As illustrated in FIG. 6A, when volume XA is larger than the volume XB, the gas supply amount in the first supply line 47A is greater than that in the second supply line 47B. In such a case, as illustrated in FIG. 6B, the regulator 60 is installed at a first supply line 147A. In the example of FIG. 6B, the regulator 60 is a reducer pipe. Here, unlike the first supply line 47A of FIG. 6A, at which the regulator 60 is not installed, in the first supply line 147A of FIG. 6B, at which the regulator 60 is installed, the gas supply amount is matched with that of the second supply line 47B within a target time (given time), as illustrated in FIG. 6C. On the other hand, as illustrated in FIG. 6C, in the first supply line 47A of FIG. 6A, at which the regulator 60 is not installed, the gas supply amount of the first supply line 47A is not matched with that of the second supply line 47B within the target time. Therefore, in the case where the volumes XA and XB differ, the gas supply amounts among the respective gas supply lines can be matched by installing the regulator 60 at at least one of a plurality of gas supply lines.

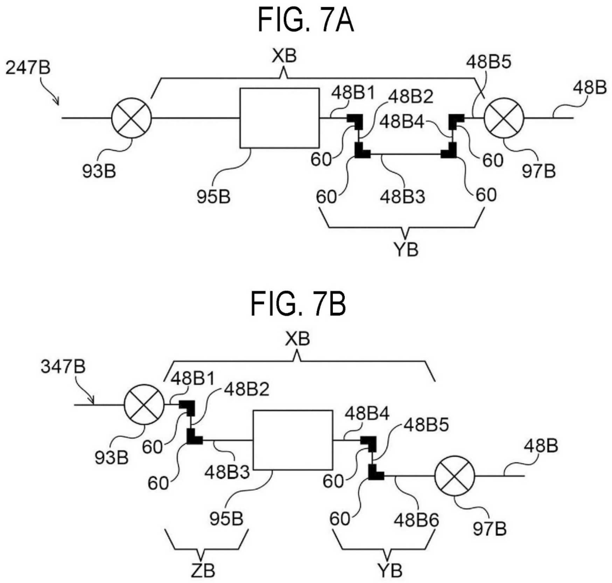

In FIG. 7A, four regulators 60 (elbow pipes) are installed at a second supply line 247B. These regulators 60 are connected by pipes 48B1, 48B2, 48B3, 48B4 and 48B5. As such, three or more regulators 60 may be installed at the second supply line 47B. By using a plurality of regulators 60, the gas supply amounts of the first supply line 47A and the second supply line 47B can be matched earlier.

Like a second supply line 347B illustrated in FIG. 7B, the second supply line 47B may include two regulators 60 (elbow pipes) installed between the inlet-side valve 93B and the second tank 95B. By using a plurality of regulators 60 in such a manner, the gas supply amounts of the first supply line 47A and the second supply line 47B can be matched earlier.

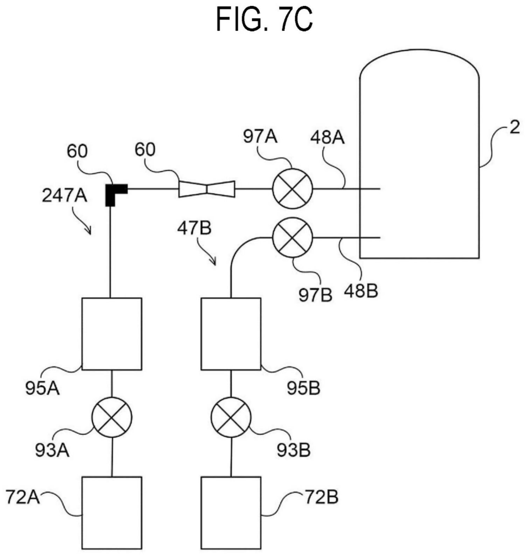

Although the regulator 60 (reducer pipe) is installed at the first supply line 147A in the modification illustrated in FIG. 6B, the present disclosure is not limited to this configuration. As a first supply line 247A as illustrated in FIG. 7C, another regulator 60 (elbow pipe) may be included between the outlet-side valve 97A and the first tank 95A. By using the regulators 60 with different structures in this manner, the gas supply amounts of the first supply line 247A and the second supply line 47B can be matched earlier.

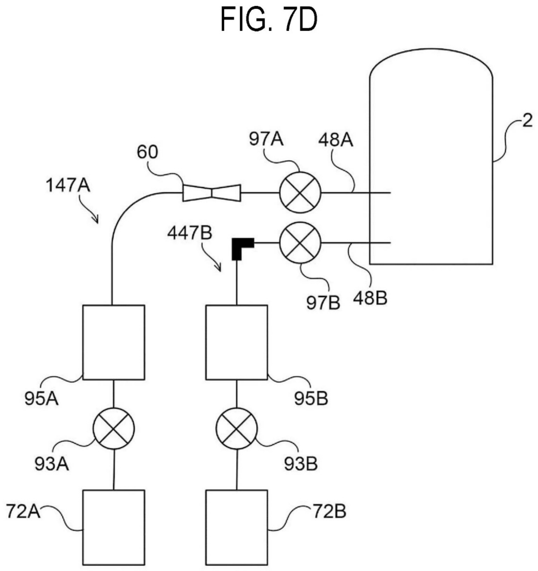

In the modification illustrated in FIG. 6B, the regulator 60 (reducer pipe) is installed in the first supply line 147A. In addition, as illustrated in FIG. 7D, a second supply line 447B may include a regulator 60 (elbow pipe). That is, each of the gas supply lines may be installed with respective regulators 60.

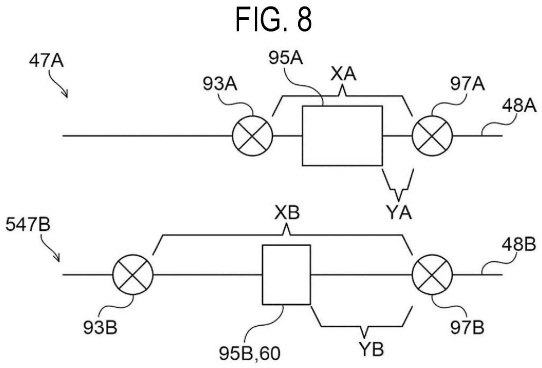

Further, for example, as a second supply line 547B illustrated in FIG. 8, the volume of the second tank 95B may be made smaller than the volume of the first tank 95A. By making the volume of the second tank 95B smaller than that of the first tank 95A in such a manner, the gas supply amounts among the respective gas supply lines can be matched. That is, by making the volume of the second tank 95B smaller than that of the first tank 95A, the second tank 95B functions as the regulator 60. In this case, the outlet-side valves 97A and 97B may be constant-level valves serving as flow-rate regulating valves, for example. Further, in the example illustrated in FIG. 8, the flow path resistance can be regulated without installing another regulator between the second tank 95B and the outlet-side valve 97B by regulating the volume of the second tank 95B, thereby matching the gas supply amounts among the respective gas supply lines within a given time.

Further, the regulator 60 is not limited to the elbow pipe. A pipe with a smaller diameter than that of the pipe that is connected to the regulator 60 may be used as the regulator 60. Further, a pipe with an orifice may be used as the regulator 60. A flow path cross-sectional area may be regulated by regulating a diameter of such a reduced-diameter portion (orifice). That is, the orifice (reduced-diameter portion) of the regulator 60 may be regarded as a portion that regulates the flow path cross-sectional area.

In the above-described embodiment, the gases are supplied into the process chamber 2 from two gas supply lines, i.e., the first supply line 47A and the second supply line 47B, but the present disclosure is not limited to this configuration. For example, the gases may be supplied into the process chamber 2 from three or more gas supply lines. Even in such cases, the gas supply amounts among the respective gas supply lines can be matched within a given time by installing the regulator 60 at each gas supply line to regulate the flow path resistance thereof, as in the embodiment described above.

### <Substrate Processing Steps>

Next, a substrate processing method including a predetermined processing step, i.e., a method of manufacturing a semiconductor device, which is performed by using the substrate processing apparatus 1 according to the present embodiment, will be described. Here, a case where the predetermined processing step is a substrate processing step, which is one of steps in a manufacturing process of a semiconductor device, will be described by way of example.

The substrate processing step is realized by executing a process recipe including at least a step of loading the substrate 31 into the process chamber 2 and a step of supplying gases from two gas supply lines, i.e., the first supply line 47A and the second supply line 47B into the process chamber 2.

When performing the substrate processing step, the process recipe is deployed in a memory (not illustrated) or the like, and control instructions and operation instructions are issued from the controller 41 to a process system controller or a transport system controller (not illustrated) as required. The substrate processing step performed in such a manner includes at least a loading step, a film formation step, and an unloading step.

### (Loading Step)

The controller 41 causes a substrate transferrer(not illustrated) to transport the substrate 31 into the process chamber 2. The number of substrates 31 that are loaded into the process chamber 2 is not limited to one. For example, when a boat (not illustrated) is loaded with a predetermined number of substrates 31, the boat is raised by a boat elevator (not illustrated) and is loaded into the process chamber 2 (boat loading). When the boat is completely loaded, a lower end of a furnace flange of the vertical furnace is airtightly closed.

### (Processing Step)

Next, the process chamber 2 is controlled according to instructions from the controller 41 to reach a predetermined temperature and a predetermined pressure (processing pressure). The process chamber 2 is heated to reach the predetermined temperature by a heater (not illustrated) according to instructions from a temperature controller (not illustrated). Then, flow rate regulation or pressure regulation is performed by an opening/closing valve with a pressure regulator (not illustrated) so as to reach the predetermined pressure.

Then, rotation of the substrate 31 is initiated by a rotator (not illustrated). In a state in which the predetermined pressure and temperature are maintained, a predetermined gas (processing gas) is supplied to the substrate 31 disposed at the process chamber 2, so that the substrate 31 undergoes a predetermined processing (e.g., film formation). In addition, before a subsequent unloading step, the temperature may be lowered from a processing temperature (predetermined temperature).

In the present embodiment, the supply of predetermined gas (processing gas) during the film formation is performed by using two gas supply lines, i.e., the first supply line 47A and the second supply line 47B. Specifically, the same type of gas is supplied from the gas supply sources 72A and 72B into the process chamber 2 via the first and second supply lines 47A and 47B, and is, for example, the gas containing a vaporized or sublimated gaseous precursor (precursor gas).

In the present embodiment, the precursor gas for film formation is supplied simultaneously for a given time from the two gas supply lines, i.e., the first supply line 47A and the second supply line 47B. Specifically, the precursor gas is supplied into the process chamber 2 from the two gas supply lines, i.e., the first supply line 47A and the second supply line 47B during a step time of the film formation in the process recipe. In other words, the step time is set as the given time in FIG. 5.

According to the present embodiment, since the same precursor gas is supplied simultaneously for a given time from the two gas supply lines, i.e., the first supply line 47A and the second supply line 47B, the accumulated supply amounts of the precursor gas can be matched, thereby improving an in-plane uniformity of film thickness.

Furthermore, according to the present embodiment, since the precursor gas may be supplied from the two gas supply lines, i.e., the first supply line 47A and the second supply line 47B, the film thickness can be increased relative to when the precursor gas is supplied from a single supply line. In particular, in film formations with large target film thicknesses, the film formation time may be shortened.

In addition, according to the present embodiment, the precursor gas accumulated in the first tank 95A passes through the first supply line 47A from the outlet-side valve 97A and is discharged from the first nozzle 56A into the process chamber 2 for a given time, and simultaneously, the precursor gas accumulated in the second tank 95B passes through the second supply line 47B from the outlet-side valve 97B and is discharged from the second nozzle 56B into the process chamber 2 for a given time. Thus, the precursor gas can flow uniformly over the substrate 31 disposed at the process chamber 2, thereby improving the in-plane uniformity of the substrate 31. Furthermore, each of the precursor gases accumulated in the first tank 95A and the second tank 95B can be supplied to the process chamber 2 at once, thereby improving step coverage in a vertical groove structure with a high aspect ratio (such as a 3D NAND structure) formed on the substrate 31.

Then, when the film formation on the substrate 31 is completed, the controller 41 stops the rotation of the substrate 31 by the rotator, substitutes the atmosphere in the process chamber 2 with nitrogen (nitrogen substitution step), and restores the internal pressure to atmospheric pressure.

### (Unloading Step)

Subsequently, the controller 41 unloads the processed substrate 31 out of the process chamber 2. The processed substrate 31 is effectively cooled, for example, by clean air blown from a cleaner (not illustrated). Then, when cooled to, for example, 150 degrees C or below, the processed substrate 31 is transferred to a pod (not illustrated) (wafer discharge). When the next batch is available, a new unprocessed substrate 31 is transferred onto the boat as required.

According to the present embodiment, one or more of the following effects may be obtained.

In the present embodiment, by regulating the flow path resistance of at least one of a plurality of gas supply lines by the regulator 60, it is possible to match the gas supply amounts from respective gas supply lines into the process chamber 2.

Further, in the present embodiment, even when there is a difference in volume among the respective gas supplies, by regulating the flow path resistance by the regulator 60, it is possible to match the gas supply amounts from the respective gas supply lines into the process chamber 2.

Further, in the present embodiment, even when there is a difference in volume among the respective gas supplies due to a piping arrangement to the process chamber 2, by regulating the flow path resistance by the regulator 60, it is possible to match the gas supply amounts from the respective gas supply lines into the process chamber 2.

Further, in the present embodiment, since the supply amounts of the same precursor gas (gas containing a vaporized or sublimated gaseous precursor) from the respective gas supply lines can be matched among the respective gas supply lines within a given time, it is possible for a thickness of a film formed on the substrate 31 which is disposed at the process chamber 2 to be made uniform.

Further, in the present embodiment, since the supply amounts of the respective gas supply lines may be cumulatively calculated using the step time of the process recipe, it is possible to predict the time at which the gas supply amounts among the respective gas supply lines are matched. Thus, it is possible to regulate the time at which the gas supply amounts are matched.

Further, according to the present embodiment, the precursor gas accumulated in the first tank 95A passes through the first supply line 47A from the outlet-side valve 97A and is discharged from the first nozzle 56A into the process chamber 2 for a given time, and simultaneously, the precursor gas accumulated in the second tank 95B passes through the second supply line 47B from the outlet-side valve 97B and is discharged from the second nozzle 56B into the process chamber 2 for a given time. Thus, the precursor gas can flow uniformly over the substrate 31 disposed at the process chamber 2, thereby improving the in-plane uniformity of the substrate 31. Furthermore, step coverage in a vertical groove structure with a high aspect ratio (such as a 3D NAND structure) can be improved.

Although the embodiments of the present disclosure have been specifically described above, the present disclosure is not limited to the above-described embodiments, and various modifications may be made without departing from the scope of the present disclosure. For example, the processing apparatus of the present embodiment may be applied to a semiconductor manufacturing apparatus or to an apparatus for processing a glass substrate such as LCD apparatus. Further, film formation may include, for example, a CVD process, a PVD process, a process of forming an oxide film, a nitride film, or both, and a process of forming a film containing a metal, and the like. Furthermore, the film formation may also be an annealing process, oxidation process, nitridation process, diffusion process, or the like.

In addition, specific embodiments of substrate processing is not limited in the above-described embodiments, and the present disclosure may be suitably applied to a case where a batch-type substrate processing apparatus which processes a plurality of substrates at once is used, or to a case where a single-wafer-type substrate processing apparatus which processes one or several substrates at a time is used. Furthermore, the present disclosure may be suitably applied to both a substrate processing apparatus including a hot-wall-type processing furnace and a substrate processing apparatus including a cold-wall-type processing furnace.

Even when these processing apparatuses are used, each processing can be performed by using the same processing procedures and processing conditions as in the above-described embodiments and modifications, and the same effects as in the above-described embodiments and modifications can be obtained.

The above-described embodiments and modifications may be used in appropriate combinations. In such cases, the processing procedures and processing conditions may be the same as those of the above-described embodiments and modifications, for example.

According to the present disclosure in some embodiments, it is possible to match the supply amounts of gases from respective gas supply lines to a process chamber.

While certain embodiments have been described, these embodiments have been presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the scope of the disclosures. The accompanying claims and their equivalents are intended to cover such forms or modifications as would fall within the scope of the disclosures.

## Claims

1. A gas supply system comprising:
a plurality of gas supply lines (47A, 147A, 247A, 47B, 247B, 347B, 447B, 547B) connected to a process chamber (2), wherein each of the plurality of gas supply lines (47A, 147A, 247A, 47B, 247B, 347B, 447B, 547B) includes an inlet-side valve (93A, 93B) through which a gas flows in, a storage (95A, 95B) in which the gas is accumulated through the inlet-side valve (93A, 93B), and an outlet-side valve (97A, 97B) through which the gas flows out of the storage (95A, 95B); and
at least one regulator (60) installed in at least one of the plurality of gas supply lines (47A, 147A, 247A, 47B, 247B, 347B, 447B, 547B) and configured to be capable of regulating a flow path resistance of the at least one of the plurality of gas supply lines (47A, 147A, 247A, 47B, 247B, 347B, 447B, 547B) such that gas supply amounts from the plurality of gas supply lines (47A, 147A, 247A, 47B, 247B, 347B, 447B, 547B) into the process chamber (2) are matched.

2. The gas supply system of Claim 1, wherein the at least one regulator (60) is a connection pipe configured to connect pipes that constitute the at least one of the plurality of gas supply lines (47A, 147A, 247A, 47B, 247B, 347B, 447B, 547B).

3. The gas supply system of Claim 1 or 2, wherein the at least one regulator (60) includes at least one selected from the group consisting of an elbow pipe, a bellows pipe, and a reducer pipe.

4. The gas supply system of any one of Claims 1 to 3, wherein the at least one regulator (60) includes a reduced-diameter portion with a diameter smaller than those of the connected pipes.

5. The gas supply system of any one of Claims 1 to 4, wherein the at least one regulator (60) includes a portion configured to regulate a flow path cross-sectional area.

6. The gas supply system of Claim 1, wherein, in a case where a volume from the inlet-side valve (93A, 93B) to the outlet-side valve (97A, 97B) via the storage (95A, 95B) differs among the plurality of gas supply lines (47A, 147A, 247A, 47B, 247B, 347B, 447B, 547B), the at least one regulator (60) regulates the flow path resistance of the at least one of the plurality of gas supply lines (47A, 147A, 247A, 47B, 247B, 347B, 447B, 547B) such that the gas supply amounts from the plurality of gas supply lines (47A, 147A, 247A, 47B, 247B, 347B, 447B, 547B) are matched.

7. The gas supply system of Claim 6, wherein the case where the volume differs among the plurality of gas supply lines (47A, 147A, 247A, 47B, 247B, 347B, 447B, 547B) includes at least one selected from the group consisting of: a case where a length of a pipe connecting the inlet-side valve (93A, 93B) and the storage (95A, 95B) differs among the plurality of gas supply lines (47A, 147A, 247A, 47B, 247B, 347B, 447B, 547B); a case where a length of a pipe connecting the storage (95A, 95B) and the outlet-side valve (97A, 97B) differs among the plurality of gas supply lines (47A, 147A, 247A, 47B, 247B, 347B, 447B, 547B); and a case where a volume of the storage (95A, 95B) differs among the plurality of gas supply lines (47A, 147A, 247A, 47B, 247B, 347B, 447B, 547B).

8. The gas supply system of any one of Claims 1 to 7, wherein the at least one regulator (60) is installed between the storage (95A, 95B) and the outlet-side valve (97A, 97B).

9. The gas supply system of any one of Claims 1 to 8, wherein the at least one regulator (60) includes a plurality of regulators (60), and
wherein the plurality of regulators (60) are each installed between the inlet-side valve (93A, 93B) and the outlet-side valve (97A, 97B) via the storage (95A, 95B).

10. The gas supply system of any one of Claims 1 to 9, wherein the plurality of regulators (60) are installed in the plurality of gas supply lines (47A, 147A, 247A, 47B, 247B, 347B, 447B, 547B) respectively.

11. The gas supply system of any one of Claims 1 to 10, wherein the at least one regulator (60) includes the storage (95A, 95B).

12. The gas supply system of any one of Claims 1 to 11, further comprising a processor,
wherein the processor is configured to be capable of calculating the gas supply amount of each of the plurality of gas supply lines (47A, 147A, 247A, 47B, 247B, 347B, 447B, 547B) based on a volume from the inlet-side valve (93A, 93B) to the outlet-side valve (97A, 97B) via the storage (95A, 95B) and a flow path resistance from the storage (95A, 95B) to the outlet-side valve (97A, 97B).

13. A processing apparatus including the gas supply system of any one of Claims 1 to 12.

14. A gas supply method comprising a process of supplying a gas by the gas supply system of any one of Claims 1 to 12.

15. A method of manufacturing a semiconductor device, comprising processing a target to be processed by supplying the gas by the gas supply method of Claim 14.
